(19)

**Europäisches Patentamt**
**European Patent Office**
**Office européen des brevets**

(11) **EP 4 730 619 A1**

(12) **EUROPEAN PATENT APPLICATION**

(43) Date of publication:
**22.04.2026 Bulletin 2026/17**

(21) Application number: **24207482.1**

(22) Date of filing: **18.10.2024**

(51) International Patent Classification (IPC):
**H02K 3/28** *(2006.01)* **H02K 7/18** *(2006.01)*
**H02K 15/50** *(2025.01)* **H02P 29/028** *(2016.01)*

(52) Cooperative Patent Classification (CPC):
**H02K 7/1838; H02K 3/28; H02K 15/50;**
**H02P 29/028;** H02K 2213/06

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Siemens Gamesa Renewable Energy**
**A/S**
**7330 Brande (DK)**

(72) Inventors:
• **AZAR, Ziad**
**S10 4ED Sheffield (GB)**
• **DAHL, Flemming**
**8600 Silkeborg (DK)**
• **GROENDAHL, Erik**
**8653 Them (DK)**
• **LI, Xing**
**7330 Brande (DK)**

• **MADANI, Nima**
**7100 Vejle (DK)**
• **REIGNER, Kevin Fabrice Franck**
**5612MD Eindhoven (NL)**
• **SUBHRA, Samanta**
**7430 Ikast (DK)**
• **SZCZESNY, Ireneusz Grzegorz**
**7160 Tørring (DK)**
• **CELILOGLU, Rifat**
**7100 Vejle (DK)**
• **SIMEONOV, Orlin Borisov**
**7100 Vejle (DK)**
• **OLSEN, Martin**
**8200 Aarhus (DK)**

(74) Representative: **SGRE-Association**
**Siemens Energy Global GmbH & Co. KG**
**SE I IM P Intellectual Property**
**Siemenspromenade 9**
**91058 Erlangen (DE)**

(54) **OPERATING A GENERATOR HAVING A FAULTY COIL**

(57)    It is described a method of operating a generator (2) having a stator (3) with at least one multi-phase winding set (4_1), the winding set comprising for each phase plural coils (5_1, 5_1*, 5_1, 16_1) arranged in slots between teeth of the stator, the plural coils in particular being connected in series and/or in parallel, in case that at least one coil (5_1*) is faulty, the method comprising: electrically disconnecting fully or partially the faulty coil (5_1*) and may or may not other healthy coils from a first conductor (7a) and another first conductor (7b); operating the generator (2) without the disconnected faulty coil (5_1*), thereby in particular keeping the disconnected faulty coil in place at the stator while the generator is in operation.

FIG 1

## Description

Field of invention

The present invention relates to a method of operating a generator in case that at least one coil is faulty. Furthermore, the present invention relates to a generator system as well as to a wind turbine.

Art Background

EP 2 629 402 A1 discloses a method of repairing a winding in a generator wherein the winding is cut on one side of the tooth to separate the winding in two parts and the two parts of the windings are removed from the tooth. Further, a substitute partial coil is slid on the tooth and incomplete turns are connected with plural conductor portions.

A faulty coil or coils in a generator (turbine), which is/are usually short-circuited turn and or coil/coils, will conventionally cause complete turbine stoppage till the segment with the faulty coil/coils is replaced (in case of segmented generator stator) or full stator replacement is possible (in case of un-segmented generator stator). Continuing operation with short-circuited coil will lead to high local temperature that ends with a bigger damage to the rest of the turbine with the risk of setting complete turbine into a fire. Normally, repairing of faulty coils is not possible. The replacement in some situations, i.e. remote onshore areas, weather conditions in off-shore areas etc., might not be possible within short period of time, as a generator dismantling equipment (e.g. full size crane) will be required which could take a few weeks and up to a few months. This will lead to a significant loss of AEP (Annual Energy Production), particularly during the wind season when the segment/full stator replacement is naturally more difficult and likely to be delayed.

In case of faults in stator coil/s, normally the turbine must stand still till the segment with faulty coil/s is replaced. In offshore direct drive turbines, although equipped with two isolated electrical systems, continuing operation with the healthy system at 50% generator capacity while disconnecting the converter of the faulty system is still risky, as the magnetic coupling of these two systems creates circulating current in faulty coil/s, flowing through a low resistance path. This can cause further damages to the rest of generator/turbine and eventually could end up with a fire alarm or even a real fire in case of fire alarm malfunction.

Thus, there may be a need of a method of operating a generator having a faulty coil and there may be a need for a generator and a wind turbine comprising the generator, wherein efficiency of the generator is improved wherein in particular power output of the generator and/or operation time of the generator may be enhanced in comparison to conventional methods.

Summary of the Invention

Embodiments of the present invention propose an isolation of one or more faulty coils which can be done in a few hours by one or two technicians. The generator system may then be put back into operation with high-load capacity, i.e. close to full power depending on the winding design of the stator and the number of faulty coils.

According to an embodiment of the present invention, it is provided a method of operating a generator having a stator with at least one multi-phase winding set (e.g. connected with at least one converter), the winding set comprising for each phase plural coils arranged in slots between teeth of the stator, the plural coils in particular being connected in series and/or in parallel, in case that at least one coil is faulty, the method comprising: electrically disconnecting the faulty coil or a portion of the faulty coil from a first conductor and another first conductor; operating the generator while keeping the disconnected faulty coil in place at the stator.

The method may for example be implemented in software and/or hardware and/or may be performed by one or more technicians or maintenance personnel and/or a control portion including arithmetic/logical circuitry and being adapted to control the generator.

The stator may be a single-segment or multiple-segment stator. The stator may comprise plural multi-phase winding sets but may also in several embodiments comprise only one multi-phase winding set. In particular, the (at least one) multi-phase winding set may provide three electrical phases or more electrical phases. The winding set may be wound or arranged in the slots between the teeth according to a concentrated winding topology or a distributed winding topology.

The generator (e.g. of a wind turbine) may further comprise a rotor, for example outer rotor, having permanent magnets mounted on the rotor for example. The rotor may rotate about an axis being parallel to an axial direction. The generator may comprise a first axial end and a second axial end. In particular, the faulty coil may be disconnected by applying one or more cuts or interruptions at the first axial end, where the windings are accessible. Embodiments may be directed to a generator or motor which is not a generator of a wind turbine.

The winding set may, for each phase, comprise one or plural coil series (also referred to as branches) in parallel connected to each other, each comprising one or plural series connected coils. Other configurations may be possible.

The electrically disconnecting may involve mechanically cutting and/or sawing through conductive (winding or wire metallic) material in order to interrupt any electrical current flowing into the faulty coil or flowing out of the faulty coil. The first conductor and another first conductor may previously carry current towards the now faulty coil and lead away the current from the previously healthy now faulty coil.

The faulty coil may for example comprise a damage at an insulation and/or a short circuit inside itself or between one or more other coils or windings belonging to one or more other phases or may include or comprise a short circuit to a stator or a neutral phase. The fault may in particular generate substantive heat if not remedied. Either the entire faulty coil or only a portion or a part of the faulty coil may be electrically disconnected depending on the application and the design and geometry and/or location of the coil considered. In particular, a conductor portion previously electrically connecting the faulty coil and the first conductor may be cut or interrupted and another conductor portion between the faulty coil and the other first conductor may be cut or interrupted. The first axial end may for example correspond to a non-drive end, i.e. the axial end where no hub with plural rotor blades is located.

The faulty coil may for example comprise a faulty isolation towards any conductive material to which in normal operation electrical current should not be conducted from or to the faulty coil.

Embodiments of the present invention may not require removing the faulty coil entirely or partially from the generator. By electrically disconnecting the faulty coil, the faulty coil may not be any more a portion of the electrical system. Thereby, the operation of the generator can be continued without requiring a cumbersome or time-consuming removal of the faulty coil. Thereby, operation of the generator can be resumed in a fast manner.

According to an embodiment of the present invention, disconnecting the faulty coil or a portion of the faulty coil comprises: interrupting a first electrical connection between the faulty coil or a portion of the faulty coil and the first conductor or a portion of the first conductor; interrupting another first electrical connection between the faulty coil or a portion of the faulty coil and the other first conductor or a portion of the other first conductor, the respective interrupting the first and/or the other first electrical connection in particular including cutting, sawing entirely through a conductive material.

The first/second electrical connection may be cut through or may be teared through for example using a knife and/or a saw which may for example be operated by maintenance personnel. In particular, the first conductor and the other first conductor may not be interfered with or damaged for interrupting the electrical connections. Advantageously, the first conductor and the other first conductor may then be capable of further being connected to and receiving current or supplying current to other still healthy coils of the generator and thereby enabling continuation of the operation of the generator.

According to an embodiment of the present invention, previous to the disconnecting the faulty coil the faulty coil was connected to a first converter via the first conductor, in particular configured as a bus bar.

The first (and also an optional second connected to a second winding set) converter may comprise plural controllable switches such as power transistors connected between two DC terminals. The first as well as the second converter may be capable of transforming a variable frequency power stream to a substantially fixed frequency power stream, for example having 50 Hz or 60 Hz. The first (as well as the second) converter may eventually allow to control the generator, for example by one or more current references or power references or torque references selected depending on the application control mode.

According to an embodiment of the present invention, disconnecting the faulty coil thereby keeps at least one or every non-faulty coil previously connected in parallel with the faulty coil connected to the first conductor and the other first conductor.

In particular, all non-faulty (e.g. healthy) coils which are not connected in series with the faulty coil may be kept connected to the first conductor and the other first conductor. Thereby, operation of the generator may continue with at least a substantial fraction of the non-faulty coils. The non-faulty coil(s) may not cause or comprise any short circuit to any conductor which should according to normal operation be electrically isolated from the considered (i.e. the faulty coil which is disconnected) coil.

According to an embodiment of the present invention, the method further comprises disconnecting, and in particular keeping in place at the stator, a non-faulty (or may be faulty) coil spatially arranged at the stator substantially opposite to the faulty coil, in particular substantially 180° offset from the faulty coil, from the first and other first conductors, in order to in particular reduce rattling and/or vibration.

By also disconnecting the coil (irrespective whether healthy or non-healthy) which is opposite to the faulty coil, imbalances of generated torque or any other mechanical or electrical imbalances may be reduced or even avoided. In particular, an entire coil series being arranged opposite to the faulty coil (series) may be disconnected from the first and the other first conductors. In other embodiments, any other opposite non-faulty coils may be kept connected to the first and the other first conductors, in particular if rattling and/or vibration is not observed to be above a threshold for example.

According to an embodiment of the present invention, the method further comprises electrically and/or mechanically separating and/or cutting the faulty coil or the portion of the faulty coil at a portion of a second axial end, in particular wherein the interrupting of a first and another first electrical connection is performed at a first axial end (thereby e.g. preventing any circulating current in the faulty coil).

Thereby, a third interruption or cut at the faulty coil may be performed, in order for example to avoid any circulating current in the faulty coil. The second axial end may correspond to the axial end, where a hub comprising plural rotor blades is located (e.g. drive-end).

According to an embodiment of the present invention, the coils of one winding set are originally connected in a star or a delta configuration; the first and other first conductors are formed by or comprise a first and another first bus bar; in case the coils of one winding set are originally connected in a star configuration, the first conductor carries electricity of one non-neutral phase (e.g. A, B, C) and the other first conductor carries electricity of a neutral phase (e.g. N).

Thereby, great flexibility is provided. The first bus bar may be connected to one terminal of the first converter. A further first and another further first bus bar may be provided for other electrical phases and may be connected to other terminals of the first converter for example. The first, the further first, the other further first as well as the other first bus bar may all be provided substantially at the first axial end of the generator providing more simple access to the conductors providing current for power production. The neutral phase may be present at the star point, when the coils of the winding sets are electrically connected in a star configuration. The star point (i.e. representing neutral phase) may not be connected to any converter.

According to an embodiment of the present invention, the faulty coil is a member of a coil series of series connected coils, a first end of the coil series being previously connected to the first conductor, a second end of the coil series being previously connected to the other first conductor, wherein interrupting the first electrical connection comprises to interrupt a connection between the first end of the coil series and the first conductor; wherein interrupting the other first electrical connection comprises to interrupt a connection between the second end of the coil series and the other first conductor.

A coil series may also be referred to as a "branch" in the context of the present application. The coil series may for example comprise two or three or even more coils (connected in series) which are spatially adjacent to each other in the circumferential direction. For example, a first coil of the coil series may comprise plural turns around a first tooth or plural teeth which is then connected to a second coil comprising plural turns around a second tooth or plural teeth circumferentially adjacent (immediately) to the first tooth/teeth for example. The coil series may for example comprise two, three, four, five or even a higher number of coils. Thereby, conventional winding designs may be supported.

According to an embodiment, a considered coil series comprises at least one faulty coil, the entire coil series may be electrically disconnected to the first conductor and the other first conductor. This may be possible, because the electrical connection between the coil series with the first and the other first conductor may be accessible for personnel.

According to an embodiment of the present invention, the stator, in particular comprising plural stator segments, has a first multi-phase winding set, in particular previously connected to a first converter, wherein in case of a faulty coil, associated with a first phase, in the first winding set, operating the generator further comprises at least one of: reducing or not reducing, in relation with operation when the coil was non-faulty, a first current reference, associated with the first phase, for the first winding set; reducing or not reducing, in relation with operation when the coil was non-faulty, a first current reference, associated with a phase different from the first phase, for the first winding set, wherein in particular the first current reference is supplied to the first converter for controlling the first converter.

The faulty coil may be considered to be associated with a first phase provided in the first winding set in the sense that the previously healthy faulty coil carried electricity corresponding to a first phase in the first winding set in the case of the now faulty coil was healthy. The first current reference may refer to a d-component and/or a q-component of a reference current, e.g. in a synchronously rotating dq-coordinate system.

Based on the first current reference the first winding sets may be controlled, in particular via a first converter. Instead of defining or setting a current reference, also a power reference and/or a torque reference and/or voltage reference may be set and may be reduced or not reduced, as required depending on the particular application. Thereby, different variants of reducing or not reducing current reference relating to the electrical phase associated with the faulty coil or any electrical phase related to the faulty coil may be provided. Reducing or not reducing may depend for example also on other operation parameters, such as noise, vibration/rattling and may be set in dependence of such other operational parameters.

While previously described or provided embodiments also (but not restricted thereto) apply to a generator having only one single multi-phase winding set, those and/or other embodiments (also) apply to a generator having multiple multi-phase winding sets such as two, three, four, five or even a higher number of (independent) winding sets. Each multi-phase winding set may be connected to a corresponding converter.

According to an embodiment of the present invention, the stator further has at least one second multiple phase winding set, in particular previously connected to a second converter, wherein in case of a faulty coil, associated with a first phase, in the first winding set, operating the generator further comprises at least one of: reducing or not reducing, in relation with operation when the coil was non-faulty, a second current reference, associated with the first phase, for the second winding set; reducing or not reducing, in relation with operation when the coil was non-faulty, a second current reference, associated with a phase different from the first phase, for the second winding set, wherein in particular the second current reference is supplied to the second converter for controlling the second converter.

Some of the embodiments of the present invention relate to a multiple winding set electrical generator and method of operating the same. Also reducing or not reducing any second current reference relating or being associated to or not to the electrical phase (associated with the faulty coil) may be performed depending on the monitoring of other electrical or operational parameters as vibration/rattling and/or any unbalance in a mechanical or electrical sense. Thereby, the performance of the generator operation may be improved.

According to an embodiment of the present invention, the first current reference and the second current reference are substantially reduced by a same percentage; or wherein the first current reference is reduced and the second current reference is not reduced; and/or wherein the first current reference for at least one phase, in particular the faulty phase, or every one of the plural phases is set such that a current carried in any parallel connected coils or parallel connected coil series of the first winding set for the considered phase, is substantially not higher compared to non-faulty situation.

When the first/second current references or power references or torque references are set to or substantially reduced by a same percentage, balance of the generator operation may be improved. In other embodiments, power output may be kept to be as high as possible, while potentially tolerating any vibrational issues or rattling issues. Furthermore, overload of the coils may be avoided thereby improving or enhancing the lifetime of the generator or in particular the stator windings.

According to an embodiment of the present invention, the stator comprises a number of n1 first stator segments at which the first winding set is arranged, wherein at each first stator segment a number of m1 coil series or branches are connected in parallel (between the first conductor and the other first conductor), wherein the first current reference is set or reduced in dependence of n1 and/or m1 and/or a number and or location of faulty coils; and/or wherein the stator comprises a number of n2 second stator segments at which the second winding set is arranged, wherein at each second stator segment a number of m2 coil series or branches are connected in parallel (between a second conductor and another second conductor), wherein the second current reference is set or reduced in dependence of n2 and/or m2 and/or a number and or location of faulty coils.

Below a methodology to derive maximum currents is described. The current reference(s) may be set to the maximum currents. The invention is however no restricted to that particular methodology.

In order to keep the current in each coil after disconnecting the faulty coil(s) to be not higher than the current before the fault with rated current, the current fed to the system may be reduced accordingly, following the equations below:

1. If the disconnection is applied only for (coil(s) belonging to) one phase, the maximum current fulfils

$$I_{max} = \frac{m-k}{m} \cdot I_N \qquad for \; k < m$$

where, $I_N$ is the rated current of this system before fault. $m$ is the number of parallel branches in this system. $k$ is the maximum of $k_1, k_2 \ldots k_n$, which are the number of faulty branches in segment 1, 2 ... n of the faulty system.

2. For $k = m$, an all-phase disconnection is recommended for the segment/segments with the maximum number of faulty branches (i.e. the whole segment/segments is/are disconnected), for the purpose of a balanced line-line voltage. For the rest segments, if still only single-phase disconnection is applied, the maximum current fulfills

$$I_{max} = \frac{n-b}{n} \cdot \frac{m-k'}{m} \cdot I_N$$

where, n is the total number of segments of this faulty system. $b$ is the number of segments which are all-phase disconnected (i.e. whole-segment disconnected). k' is the maximum of $k_1, k_2 \ldots k_{n\text{-}b}$, which are the number of faulty branches in the rest segment 1, 2 ... n-b.

3. If the disconnection is applied for (coil(s) belonging to) multiple phases, which means whenever a coil is disconnected, the same number of coils for other phases are also disconnected for the purpose of balanced multi-phase system, the maximum current fulfills

$$I_{max} = \frac{n \cdot m - x}{n \cdot m} \cdot I_N$$

where, x is the total number of disconnected branches of each phase in all segments of this system.

The current reference(s) mentioned above may be set to the thus calculated maximum current(s). Further reducing or not reducing of the current(s) may depend for example also on other operation parameters, such as noise, vibration/rattling and may be set in dependence of such other operational parameters.

It should be understood, that features, individually or in any combination, described, explained, provided or applied to a method of operating a generator may are also, individually or in any combination, applicable or provided to a generator system according to an embodiment of the present invention and vice versa.

According to an embodiment of the present invention, it is provided a generator system comprising: a generator having a stator with at least one multi-phase winding set (e.g. connected with at least one converter), the winding set comprising for each phase plural coils arranged in slots between teeth of the stator, the plural coils in particular being connected in series and/or in parallel, at least one coil of the plural coils being faulty and being electrically disconnected from a first conductor and another first conductor; a controller being adapted to operate the generator without the faulty coil, thereby in particular keeping the disconnected faulty coil in place at the stator.

The generator system may be configured to perform a method of operating the generator as has been explained or provided in one of the embodiments above.

According to an embodiment of the present invention, it is provided a wind turbine comprising: a hub having plural rotor blades being mounted thereon; a generator system according to the preceding embodiment, a generator rotor being coupled to the hub.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

Brief Description of the Drawings

Embodiments of the present invention are now described with reference to the accompanying drawings. The invention is not restricted to the illustrated or described embodiments.

Fig. 1 schematically illustrates a wind turbine according to an embodiment of the present invention including a generator system according to an embodiment of the present invention;

Figs. 2, 3, 4 illustrate embodiments where a faulty coil is disconnected and/or interrupted at two or more portions;

Figs. 5-8 schematically illustrate two multi-phase winding set stators with different coil fault scenarios.

Detailed Description

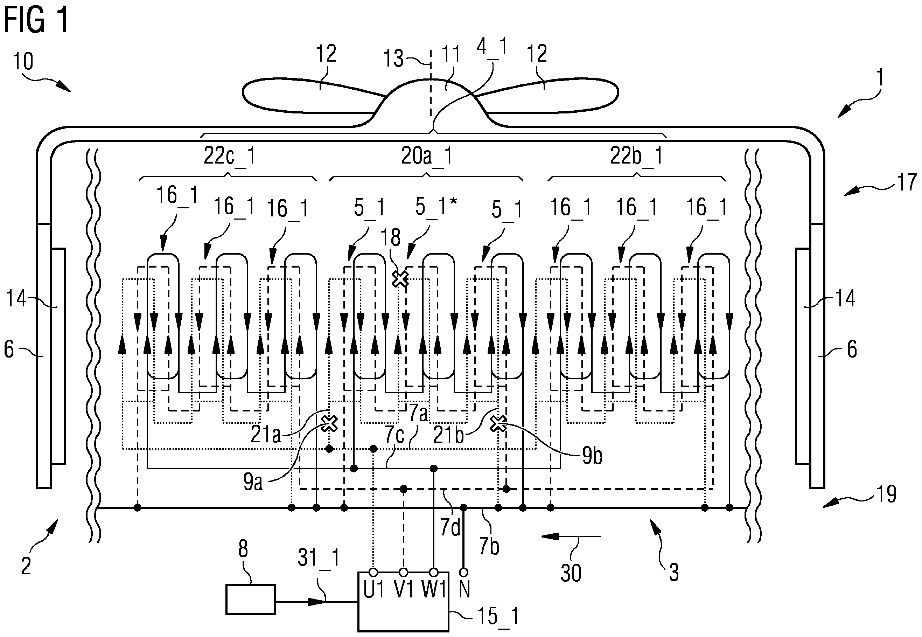

The wind turbine 10 schematically illustrated in Fig. 1 comprises a hub 11 at which plural rotor blades 12 are mounted. The hub 11 is configured to rotate about a rotational axis 13 being vertically oriented in Fig. 1. The wind turbine 10 further comprises a generator system 1 according to an embodiment of the present invention, wherein a generator rotor 6 is coupled to the hub 11. The generator rotor 6 comprises plural permanent magnets 14.

The rotation axis 13 of the rotor is parallel to an axial direction. The winding system as well as the stator is illustrated in Fig. 1 in a rolled-off illustration. In this rolled-off illustration, the circumferential direction is parallel to the horizontal direction, the rotor runs in a horizontal direction 30 in Fig. 1.

The generator system 1 comprises a generator 2, which has a stator 3 with at least one multi-phase winding set 4_1 comprising for each phase plural coils 5_1 arranged in slots (not illustrated) between teeth of the stator 3. In the embodiment illustrated in Fig. 1 the plural coils 5_1 are connected in series. At least one of the coils, namely the coil 5_1* is faulty.

In the generator system 1 illustrated in Fig. 1, the faulty coil 5_1* is electrically disconnected from a first conductor 7a and from another first conductor 7b. The generator system 1 further comprises a controller 8 which is being adapted to operate the generator 2 without the faulty coil 5_1* while thereby in particular keeping the disconnected faulty coil 5_1* in place in the stator 3.

During a method of operating the generator 2, the faulty coil 5_1* is electrically disconnected from the first conductor 7a and the other first conductor 7b. Furthermore, the generator 2 is operated without the faulty coil 5_1*.

In order to disconnect the faulty coil 5_1*, the method comprises interrupting a first electrical connection 9a between the faulty coil 5_1* and the first conductor 7a and further comprises interrupting another first electrical connection 9b between the faulty coil 5_1* and the other first conductor 7b. Previous to the disconnection of the faulty coil 5_1* the faulty coil was connected to a first converter 15_1 via the first conductor 7a.

The multi-phase winding set 4_1 comprises other still healthy coils 16_1 which are kept connected to the first conductor 7a and the other first conductor 7b.

In the embodiment illustrated in Fig. 1, the faulty coil 5_1* is also separated and/or cut at a portion of a second axial end 17. Thereby, an electrical connection 18 at the second axial end 17 of the faulty coil 5_1* is interrupted. It should be understood that in the illustrated embodiment, the interrupting the first and the other first electrical connections 9a, 9b is performed at a first axial end 19.

In the embodiment illustrated in Fig. 1 and also the following figures, the coils of the winding set 4_1 are originally connected in a star configuration and the first conductor 7a carries electricity of one non-neutral phase (in the present embodiment the phase U or phase A) and the second conductor 7c carries the neutral phase (e.g. N).

In the embodiment illustrated in Fig. 1, the faulty coil 5_1* is a member of a coil series 20a_1 of series connected coils 5_1, 5_1*, 5_1. A first coil end 21a of the coil series 20a_1 was previously connected to the first conductor 7a and a second coil end 21b of the coil series 20a_1 was previously connected to the other first conductor 7b. To interrupt the first electrical connection 9a comprises to interrupt a connection between the first coil end 21a and the first conductor 7a. To interrupt the second electrical connection 9b comprises to interrupt a connection between the second coil end 21b of the coil series and the other first conductor 7b.

As can be seen in Fig. 1, previously, the coil series 20a_1 (the one with the faulty coil 5_1*) as well as the coil series 22c_1 as well as 22b_1 were connected in parallel to the first conductor and the other first conductor 7a, 7b, respectively.

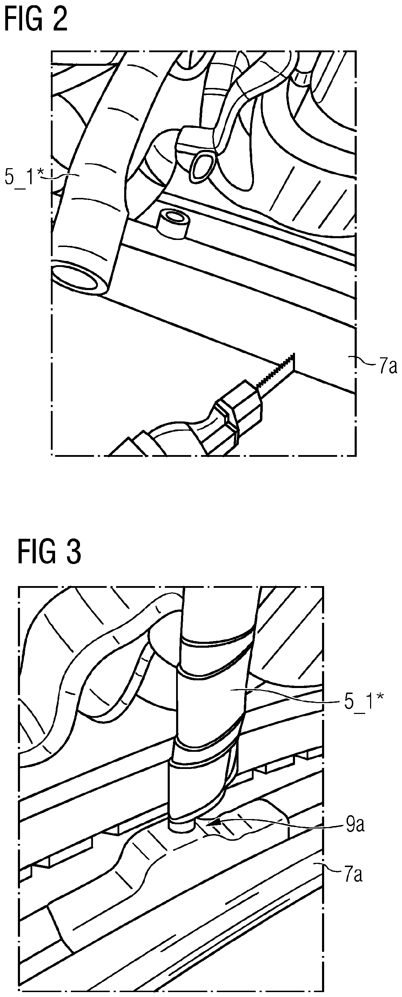

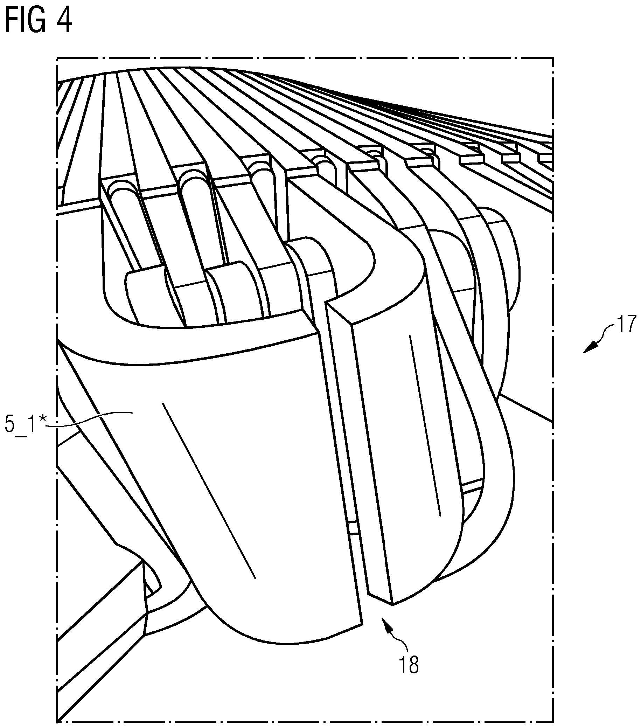

**Figs. 2 to** 4 illustrate interrupting/cutting a faulty coil from a conductor in practical examples.

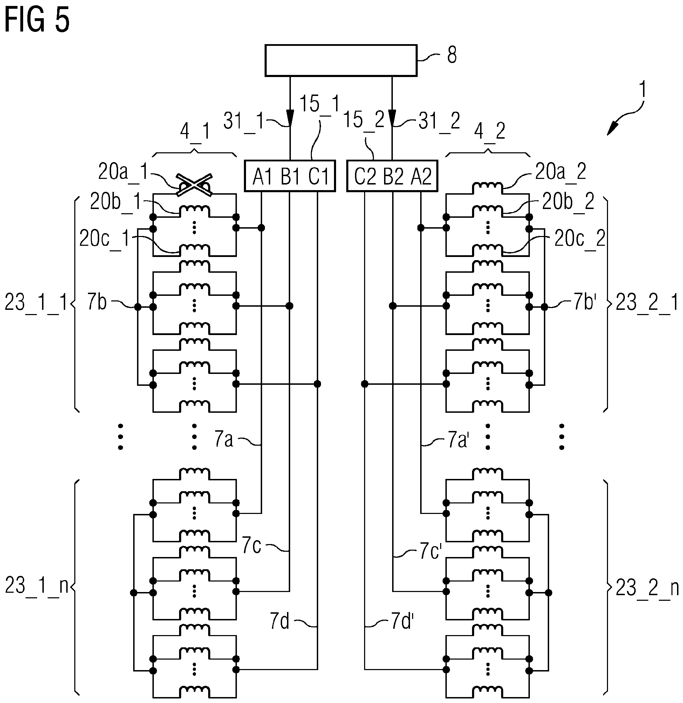

Figs. 5 to 8 illustrate a two winding set generator in a schematic manner having a first multi-phase winding set 4_1 (arranged at stator segments 1 to n) and having a second multi-phase winding set 4_2 (arranged at stator segments n+1 to 2n) being respectively connected to a first converter 15_1 and a second converter 15_2. The controller 8 controls the two converters 15_1, 15_2 by providing respective control signals 31_1 and 31_2. The control signals may for example represent a first current reference and a second current reference, respectively.

The generator system 1 illustrated in **Fig. 5** comprises for example for the first winding set 4_1 m parallel branches or coil series 20a_1, 20b_1, 20c_1 for the phase A1 for a first segment 23_1_1. Other coil series for a first segment 23_1_1 are provided for other phases B1, C1 and connected to conductors 7c, 7d, as illustrated. Thereby, the coil series 20a_1, 20b_1, 20c_1 may comprise plural series connected coils, similar as the coil series 20a_1 illustrated in Fig. 1. In the embodiment illustrated in Fig. 5, the coil series 20a_1 comprises at least one faulty coil and is then disconnected from the first conductor 7a as well as from another first conductor 7b (a neutral point).

In Fig. 5 an example of a generator design with 2n segments (23_1_1, ..., 23_1_n) and (23_2_1, ..., 23_2_n) distributed with two winding systems 4_1, 4_2 is shown. In each segment, each phase is designed with m parallel branches. Phase A1 of segment 1 has one (20a_1) of its branches disconnected due to a faulty coil. The proposed solution states that in this example, the current level of phase A of the winding system 4_2 shall be reduced correspondingly. So that seen by either of the converters, the current level in phase A is reduced similarly. The reduced current level should ensure the current in each branch is not higher than the level in healthy case with rated current supply, and simultaneously the line voltage is not higher than rated voltage.

Taking m = 2, n = 6 as an example, the current in system 4_1 must be reduced by 50% considering the above stated current and voltage limitations. For system 4_2, the current should also be reduced by 50%. Thus, 50% of the rated output power can be achieved without overheat, high noise and vibration, magnet module rattling issues, etc. If the magnet module rattling is not a critical issue (e.g. for magnet modules with bolt- or glue-fixation), the current in system 4_2 can remain unchanged (i.e. fully loaded). Thus, 75% of the rated output power can be achieved.

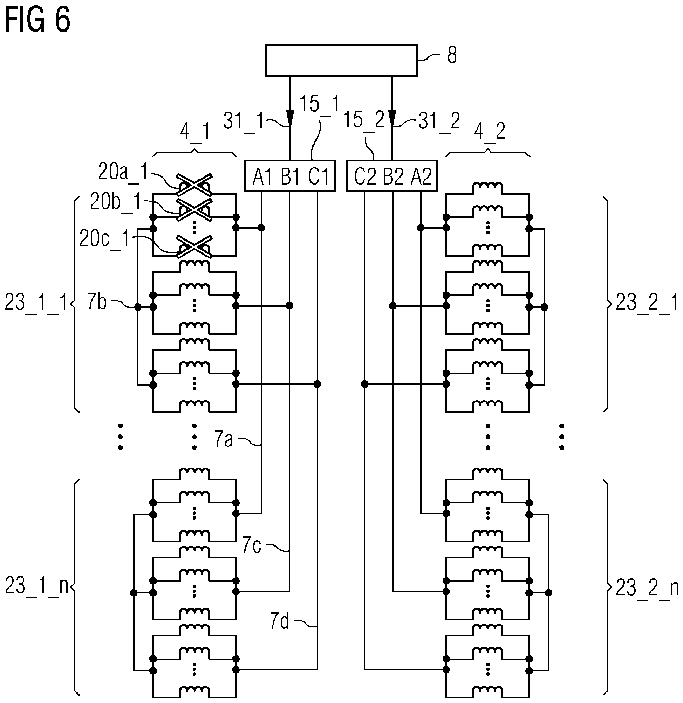

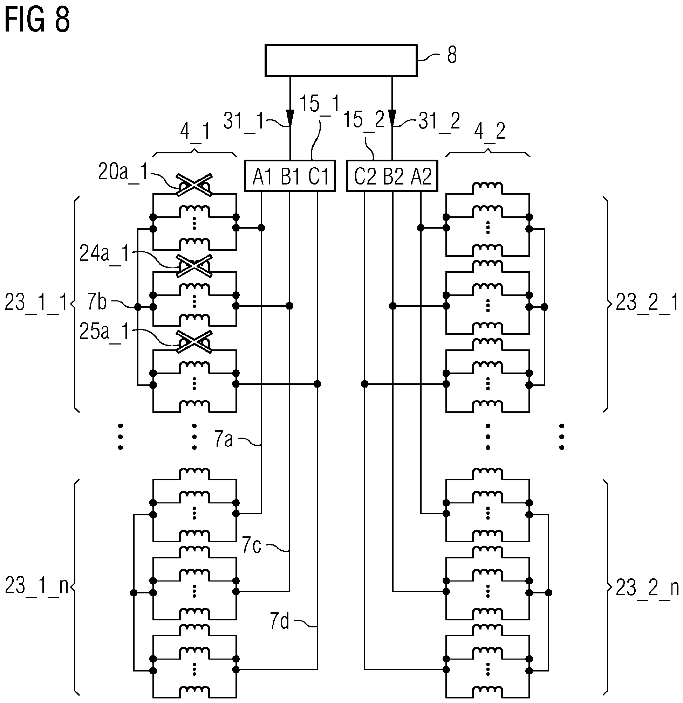

The stated solution is also appliable but not limited for different fault conditions and different disconnection scenarios shown in Fig. 6 to Fig. 8 as examples. It should be understood that Figs. 6-8 not only show fault conditions, but different cut options, even on healthy coils. Especially regarding Fig. 8, it can be that only phase A has faulty coils, but still phase B and C may be disconnected, in order to balance three phase system, for example.

In the scenario illustrated in **Fig. 6,** the coil series 20a_1, 20b_1 and 20c_2 each comprise at least one coil disconnected from the system, namely from the first conductor 7a and the other first conductor 7b.

For fault in Fig. 6, all the coils of phase A in one segment of system 4_1 are disconnected. Taking m = 2, n = 6 as an example, the currents in system 4_1 and system 4_2 must be both reduced to 25% considering the above stated current and voltage limitations. Thus, 25% of the rated output power can be achieved without overheat and magnet module rattling issues, etc. If the magnet module rattling is not a critical issue (e.g. for magnet modules with bolt- or glue-fixation), the current in system 4_2 can remain unchanged (i.e. fully loaded). Thus, 62.5% of the rated output power can be achieved.

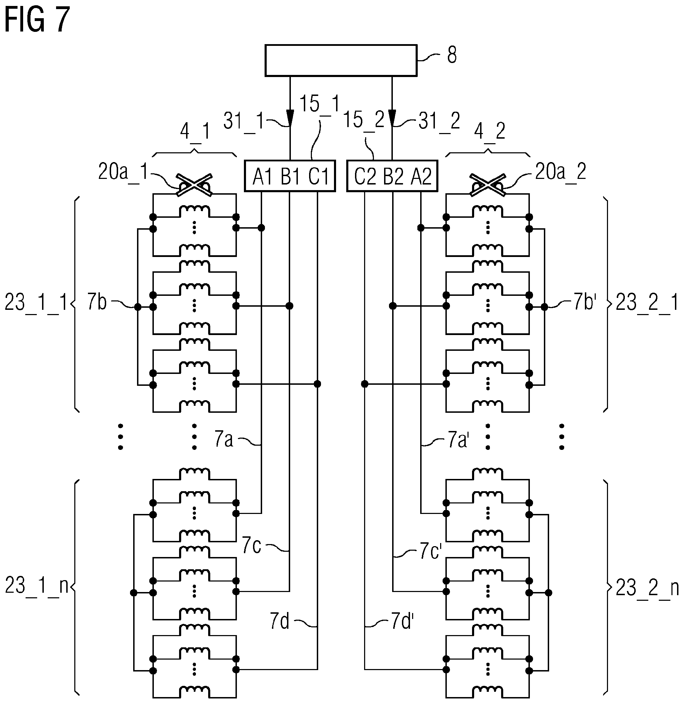

In the scenario illustrated in **Fig. 7,** the coil series 20a_1 of the first winding set 4_1 as well as the coil series 20a_2 of the second winding set 4_2 comprise at least one coil disconnected from the respective first conductor 7a, 7a' and the other first conductor 7b and 7b'.

For fault in Fig. 7, with one disconnected coil of phase A in one segment of system 4_1, and one disconnected coil of phase A in one segment of system 4_2, taking m = 2, n = 6 as an example, the currents in system 4_1 and system 4_2 must be both reduced by 50% considering the above stated current and voltage limitations. Thus, 50% of the rated output power can be achieved without overheat and magnet module rattling issues, etc. Even if the magnet module rattling is not a critical issue (e.g. for magnet modules with bolt- or glue-fixation), the current in system 4_2 still must be reduced due to the current and voltage limitations. Thus, 50% of the rated output power can be achieved.

In the embodiment illustrated in **Fig. 8,** for the first winding set 4_1, coil series 20a_1 of phase A1, coil series 24a_1 of phase B1 and coil series 25a_1 of phase C1 comprise at least one coil according to an embodiment disconnected from the first conductor 7a and the second conductor 7b.

For fault in Fig. 8, with one disconnected coil in phase A, B, C respectively in one segment of system 4_1, taking m = 2, n = 6 as an example, the currents in system 4_1 and system 4_2 must be both reduced by 50% concerning the magnet module rattling issues. Thus, 50% of the rated output power can be achieved. If the magnet module rattling is not a critical issue (e.g. for magnet modules with bolt- or glue-fixation), the current in system 4_2 can remain unchanged (i.e. fully loaded). And the current reduction in system 4_1 can be only reduced by 16.7% instead of 50%. Thus, 91.7% of the rated output power can be achieved.

The faulty coil/s can be simply dis-connected from the generator busbars on the non-drive end side so they are not part of the electrical system of generator anymore, also cut open through end-winding on the drive end to prevent any circulating current, so turbine operation can be safely continued. The faulty coil may be isolated and the turbines have been put back into operation with for example 70% load capacity.

The limitation for not achieving even higher power has been the vibration due to the unbalanced forces generated by electrical imbalance in the system and/or magnet module rattling and/or unbalanced magnet circuit. A method to improve it, can be a symmetric coil dis-connection, i.e. remove faulty coil/s and opposite healthy coil/s. It depends on the situation, number of faulty coils and their positions to consider this scenario as an option to improve the maximum possible power capacity, in the same time might require replacement of a non-faulty segments.

The advantage of such operation is removing a faulty coil/s (stator faults) and put back a stopped turbines safely into operation with relatively high power capacities at very low cost and short time. This means a significant AEP increase, practically when the replacement of segment (generator dismantling) is not possible.

Another big advantage could be to keep operating the turbine with isolated coil/s, so no segment replacement, this is particularly beneficial toward the end life of turbines, when such faults become more possible due to aging of insulation system and replacement of segment is not cost effective. In other word, potentially extending lifetime of turbines.

Embodiments of the present invention may allow for continued operation of turbine having generator with one or more faulty coils to keep the energy production. This is done by physically disconnecting (cut-out coil heads) the unhealthy and may or may not other healthy coil/s, however, to ensure safe and reliable turbine operation, i.e. low noise and vibration, unbalanced magnetic pull nor magnet module rattling. This simultaneously may include reducing the current level passing through the corresponding healthy coils as well. In multi winding system generators the reduction may be the same for systems, i.e. including the ones without cut-out coils.

An advantage of embodiments may be to allow for equal or higher power production than that of the reduced converter operation (RCO) solution. To keep a turbine in operation with a generator having faulty coils, i.e. keep the power production till a generator replacement become possible, as in off-shore the weather could prevent the replacement for weeks/months.

The solution can also include current reduction of all 3 phases of the healthy coils in the healthy winding system, counterpart to the faulty coil in the unhealthy winding system. This also may require the current level reduction of the healthy coils of the 2 other phases of a faulty coil in the faulty winding system.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

**Claims**

1. Method of operating a generator (2) having a stator (3) with at least one multi-phase winding set (4_1), the winding set comprising for each phase plural coils (5_1, 5_1*, 5_1) arranged in slots between teeth of the stator, the plural coils in particular being connected in series and/or in parallel, in case that at least one coil (5_1*) is faulty, the method comprising:

    electrically disconnecting the faulty coil (5_1*) or a portion of the faulty coil from a first conductor (7a) and another first conductor (7b);
    operating the generator (2) without the faulty coil (5_1*), thereby in particular keeping the disconnected faulty coil in place at the stator while the generator is in operation.

2. Method according to the preceding claim, disconnecting the faulty coil (5_1*) or a portion of the faulty coil comprises:

    interrupting a first electrical connection (9a) between the faulty coil (5_1*) or a portion of the faulty coil and the first conductor (7a) or a portion of the first conductor;
    interrupting another first electrical connection (9b) between the faulty coil (5_1*) or a portion of the faulty coil and the other first conductor or a portion of the other first conductor (7b),
    the respective interrupting the first and/or the other first electrical connection in particular including cutting, sawing entirely through the conductive materials.

3. Method according to any one of the preceding claims, wherein previous to the disconnecting the faulty coil (5_1*) the faulty coil was connected to a first converter (15_1) via the first conductor (7a), in particular configured as a bus bar.

4. Method according to any one of the preceding claims, wherein disconnecting the faulty coil (5_1*) thereby keeps at least one or every non-faulty coil (16_1) previously connected in parallel with the faulty coil connected to the first conductor and the other first conductor.

5. Method according to any one of the preceding claims, further comprising:
disconnecting, and in particular keeping in place at the stator, a non-faulty coil spatially arranged at the stator substantially opposite to the faulty coil, in particular substantially 180° offset from the faulty coil, from the first and other first conductors, in order to in particular reduce rattling and/or vibration and/or unbalance magnetic loads.

6. Method according to any one of the preceding claims, further comprising:
electrically and/or mechanically separating and/or cutting the faulty coil (5_1*) or the portion of the faulty coil at a portion of a second axial end (17), in particular wherein the interrupting a first and another first electrical connection is performed at a first axial end (19).

7. Method according to any one of the preceding claims, wherein at least one of the following holds:

the coils of one winding set are originally connected in a star or a delta configuration;
the first and other first conductors (7a, 7b) are formed by or comprise a first and another first bus bar;
in case the coils of one winding set are originally connected in a star configuration, the first conductor carries electricity of one non-neutral phase (A, B, C) and the other first conductor carries electricity of a neutral phase (N).

8. Method according to any one of the preceding claims,

wherein the faulty coil (5_1*) is a member of a coil series (20a_1) of series connected coils, a first coil end (21a) of the coil series being previously connected to the first conductor (7a), a second coil end (21b) of the coil series being previously connected to the other first conductor (7b),
wherein interrupting the first electrical connection comprises to interrupt a connection between the first coil end (21a) of the coil series and the first conductor;
wherein interrupting the other first electrical connection comprises to interrupt a connection between the second coil end (21b) of the coil series and the other first conductor.

9. Method according to any one of the preceding claims,

wherein the stator, in particular comprising plural stator segments (23_1_1, ..., 23_1_n), has a first multi-phase winding set (4_1), in particular previously connected to a first converter (15_1), wherein in case of a faulty coil (5_1*), associated with a first phase (A1), in the first winding set (4_1), operating the generator further comprises at least one of:

reducing or not reducing, in relation with operation when the coil was non-faulty, a first current reference (31_1), associated with the first phase (A1), for the first winding set (4_1);
reducing or not reducing, in relation with operation when the coil was non-faulty, a first current reference, associated with a phase different from the first phase, for the first winding set,

wherein in particular the first current reference is supplied to the first converter for controlling the first converter.

10. Method according to the preceding claim, wherein the stator further has at least one second multiple phase winding set (4_2), in particular previously connected to a second converter (15_2),

wherein in case of a faulty coil (5_1*), associated with a first phase (A1), in the first winding set (4_1), operating the generator further comprises at least one of:

reducing or not reducing, in relation with operation when the coil was non-faulty, a second current reference (31_2), associated with the first phase (A2), for the second winding set (4_2);
reducing or not reducing, in relation with operation when the coil was non-faulty, a second current reference, associated with a phase different from the first phase, for the second winding set,

wherein in particular the second current reference is supplied to the second converter for controlling the second converter.

11. Method according to the preceding claim,

wherein the first current reference (31_1) and the second current reference (31_2) are substantially reduced by a same percentage; or
wherein the first current reference is reduced and the second current reference is not reduced; and/or
wherein the first current reference for at least one phase, in particular the faulty phase, or every one of the plural phases is set such that a current carried in any parallel connected coils or parallel connected coil series of the first winding set for the considered phase, is substantially not higher compared to non-faulty situation.

**12.** Method according to any one of the preceding claims,

wherein the stator comprises a number of n1 first stator segments (23_1_1,...23_1_n1) at which the first winding set (4_2) is arranged, wherein at each first stator segment a number of m1 coil series or branches are connected in parallel (between the first conductor and the other first conductor), wherein the first current reference is set or reduced in dependence of n1 and/or m1 and/or a number and or location of faulty coils; and/or
wherein the stator comprises a number of n2 second stator segments (23_2_1, ... 23_2_n2) at which the second winding set is arranged, wherein at each second stator segment a number of m2 coil series or branches are connected in parallel between a second conductor and another second conductor (7a', 7b'), wherein the second current reference is set or reduced in dependence of n2 and/or m2 and/or a number and or location of faulty coils.

**13.** Generator system (1) comprising:

a generator (2) having a stator (3) with at least one multi-phase winding set (4_1, 4_2), the winding set comprising for each phase plural coils (5_1, 5_1*, 5_1, 16_1) arranged in slots between teeth of the stator, the plural coils in particular being connected in series and/or in parallel, at least one coil (5_1*) of the plural coils being faulty and being electrically disconnected from a first conductor (7a) and another first conductor (7b);
a controller (8) being adapted to operate the generator (2) without the faulty coil (5_1*), thereby in particular keeping the disconnected faulty coil in place at the stator.

**14.** Wind turbine (10), comprising:

a hub (11) having plural rotor blades (12) being mounted thereon;
a generator system (1) according to the preceding claim, a generator rotor (6) being coupled to the hub (11).

FIG 1

## FIG 2

## FIG 3

FIG 4

5_1*

17

18

FIG 5

# FIG 6

FIG 7

# FIG 8

EUROPEAN SEARCH REPORT

**Application Number**

EP 24 20 7482

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 062 436 A1 (SIEMENS AG [DE]) 31 August 2016 (2016-08-31) | 1-9, 12-14 | INV. H02K3/28 |
| Y | * paragraphs [0002], [0008], [0016], [0020], [0021], [0026], [0027]; claims 1,2,4; figures 1-4 * | 10,11 | H02K7/18 H02K15/50 H02P29/028 |
| X | GB 2 616 027 A (SAFRAN ELECTRICAL & POWER [GB]) 30 August 2023 (2023-08-30) | 1-3,7,13 | |
| Y | * pages 5,10; claims 1,2,4; figures 1-3 * | 10,11 | |
| A | WO 2023/030875 A1 (SIEMENS GAMESA RENEWABLE ENERGY AS [DK]) 9 March 2023 (2023-03-09) * figures 1-5 * | 1-14 | |
| A | EP 2 629 402 B1 (GE RENEWABLE TECH WIND BV [NL]) 30 September 2020 (2020-09-30) * figures 1,2 * | 1-14 | |

**TECHNICAL FIELDS SEARCHED (IPC)**

H02K
H02P

The present search report has been drawn up for all claims

| Place of search | Date of completion of the search | Examiner |
|---|---|---|
| The Hague | 20 March 2025 | Kovacsovics, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 7482

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2025

| Patent document cited in search report | | Publication date | Patent family member(s) | | Publication date |
|---|---|---|---|---|---|
| EP 3062436 | A1 | 31-08-2016 | NONE | | |
| GB 2616027 | A | 30-08-2023 | CN | 119032480 A | 26-11-2024 |
| | | | EP | 4466768 A1 | 27-11-2024 |
| | | | GB | 2616027 A | 30-08-2023 |
| | | | WO | 2023161622 A1 | 31-08-2023 |
| WO 2023030875 | A1 | 09-03-2023 | CN | 117916988 A | 19-04-2024 |
| | | | EP | 4142120 A1 | 01-03-2023 |
| | | | EP | 4324077 A1 | 21-02-2024 |
| | | | KR | 20240012587 A | 29-01-2024 |
| | | | US | 2024356415 A1 | 24-10-2024 |
| | | | WO | 2023030875 A1 | 09-03-2023 |
| EP 2629402 | B1 | 30-09-2020 | CN | 104247222 A | 24-12-2014 |
| | | | EP | 2629402 A1 | 21-08-2013 |
| | | | US | 2013212869 A1 | 22-08-2013 |
| | | | WO | 2013124255 A2 | 29-08-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2629402 A1